# EUROPÄISCHE PATENTSCHRIFT

(11) **EP 1 711 643 B1**
(45) Veröffentlichungstag und Bekanntmachung des Hinweises auf die Patenterteilung: **16.03.2011**
(21) Anmeldenummer: 04798047.9
(22) Anmeldetag: 23.11.2004
(51) Int. Cl.: C23C 14/06, C23C 14/35, B05D 7/24

(54) **VERFAHREN ZUR HERSTELLUNG EINES ULTRABARRIERE-SCHICHTSYSTEMS**
METHOD FOR THE PRODUCTION OF AN ULTRA BARRIER LAYER SYSTEM
PROCEDE DE PRODUCTION D'UN SYSTEME DE COUCHE BARRIERE ULTRA

(30) Priorität: 02.02.2004 DE 102004005313
(43) Veröffentlichungstag der Anmeldung: 18.10.2006
(73) Patentinhaber: Fraunhofer-Gesellschaft zur Förderung der angewandten Forschung e.V., 80686 München (DE)
(72) Erfinder: CHARTON, Christoph, 83437 Furth im Wald (DE); FAHLAND, Matthias, 01259 Dresden (DE); KRUG, Mario, 01844 Neustadt/Sachsen (DE); SCHILLER, Nicolas, 01833 Stolpen, OT Helmsdorf (DE); STRAACH, Steffen, 01187 Dresden (DE)
(86) Internationale Anmeldenummer: PCT/EP2004/013258
(87) Internationale Veröffentlichungsnummer: WO 2005/073427

(56) Entgegenhaltungen:
- EP-B- 0 815 283
- BURROWS P E ET AL: "Ultra barrier flexible substrates for flat panel displays" DISPLAYS ELSEVIER UK, Bd. 22, Nr. 2, Mai 2001 (2001-05), Seiten 65-69, XP002342349 ISSN: 0141-9382
- AFFINITO J D: "HYBRIDIZATION OF THE POLYMER MULTI-LAYER (PML) DEPOSITION PROCESS" SURFACE AND COATINGS TECHNOLOGY, ELSEVIER, AMSTERDAM, NL, Bd. 133/134, November 2000 (2000-11), Seiten 528-534, XP001058306 ISSN: 0257-8972

## Beschreibung

Die Erfindung betrifft ein Verfahren zur Herstellung eines transparenten Ultrabarriere-Schichtsystems durch Vakuumbeschichtung.

Barriereschichten dienen der Diffusionshemmung. Sie vermindern die Permeation durch ein beschichtetes Substrat. Häufige Anwendungen finden sich dort, wo verhindert werden soll, dass bestimmte Substanzen, z. B. Lebensmittel als Verpackungsgut, mit Sauerstoff aus der Umgebung in Kontakt kommen oder Wasser mit der Umgebung austauschen können. Dabei steht in erster Linie eine oxidative Umsetzung oder Verderblichkeit der zu schützenden Substanzen im Brennpunkt des Interesses. Daneben kommt unter anderem auch der Schutz verschiedenster oxidationsgefährdeter Substanzen in Betracht, wenn diese in Schichtverbunde integriert sind. Besondere Bedeutung kommt dem Schutz dieser Substanzen zu, wenn die Verzögerung der oxidativen Umsetzung die Lebensdauer von Produkten bestimmt.

Barriereschichten setzen verschiedenen diffundierenden Substanzen teilweise einen sehr unterschiedlichen Widerstand entgegen. Zur Charakterisierung von Barriereschichten wird häufig die Permeation von Sauerstoff (OTR) und Wasserdampf (WVTR) unter definierten Bedingungen durch die mit der Barriereschicht versehenen Substrate herangezogen. Barriereschichten haben außerdem oft die Aufgabe einer elektrischen lsolationsschicht. Ein wichtiges Einsatzgebiet von Barriereschichten stellen Display-Anwendungen dar.

Durch Beschichtung mit einer Barriereschicht wird die Permeation durch ein beschichtetes Substrat um einen Faktor verringert, der im einstelligen Bereich liegen oder viele Größenordnungen betragen kann. Unter Ultrabarriere-Schichten werden im Sinne der Ereindung Schichten verstanden, deren Barrierewirkung verhindert, dass Permeationswerte von WVTR = 0,05 g/m²d und OTR = 0,2 cm³/m²d überschritten werden (WVTR gemäß DIN 53122-2-A; OTR gemäß DIN 53380-3).

Häufig werden außer vorgegebenen Barrierewerten verschiedene andere Zielparameter von einer fertigen Barriereschicht erwartet, Beispielhaft stehen hierfür optische, mechanische sowie technologisch-ökonomische Anforderungen. Barriereschichten sollen oftmals unsichtbar sein, müssen also im sichtbaren Spektralbereich nahezu vollständig transparent sein. Werden Barriereschichten in Schichtsystemen eingesetzt, ist es häufig vorteilhaft, wenn Beschichtungsschritte zum Aufbringen einzelner Teile des Schichtsystems miteinander kombinierbar sind.

Einen wichtigen Platz unter den Beschichtungsverfahren, die bei der Herstellung von Schichtsystemen zum Einsatz kommen, nehmen Kathodenzerstäubungsverfahren, sogenannte Sputterverfahren, ein, da diese die Abscheidung von Schichten hoher Qualität ermöglichen. Bei der Herstellung von Schichtsystemen ist es daher oft wünschenswert, Sputterverfahren zumindest in Kombination mit anderen Beschichtungsverfahren einsetzen zu können.

Zur Herstellung von Barriereschichten werden häufig sogenannte PECVD-Verfahren (plasma enhanced chemical vapor deposition) eingesetzt. Diese kommen auf verschiedensten Substraten für unterschiedliche Schichtmaterialien zum Einsatz. Es ist beispielsweise bekannt, auf 13 µm PET-Substraten SiO₂- und Si₃N₄ Schichten einer Dicke von 20 bis 30 nm abzuscheiden [A. S. da Silva Sobrinho et al., J. Vac. Sci. Technol. A 16(6), Nov/Dec 1998, p. 3190-3198]. Bei einem Arbeitsdruck von 10 Pa lassen sich auf diese Weise Permeationswerte von WVTR = 0,3 g/m²d und OTR = 0,5 cm³/m²d erreichen.

Bei der Beschichtung mit SiOₓ, für transparente Barriereschichten auf PET Substrat mittels PECVD lässt sich eine Sauerstoffbarriere von OTR = 0,7 cm³/m²d realisieren [R. J. Nelson and H. Chatham, Society of Vacuum Coaters, 34th Annual Technical Conference Proceedings (1991) p. 113-117]. Auch andere Quellen zu dieser Technologie gehen für transparente Barriereschichten auf PET-Substrat von Permeationswerten in der Größenordnung WVTR = 0,3 g/m²d und OTR = 0,5 cm³/m²d aus [M. Izu, B. Dotter, S. R. Ovshinsky, Society of Vacuum Coaters, 36th Annual Technical Conference Proceedings (1993) p. 333-340].

Nachteile der bekannten PECVD-Verfahren bestehen vor allem im Erreichen relativ geringer Barrierewirkungen. Das macht die Produkte insbesondere für Displayanwendungen uninteressant. Ein weiterer Nachteil besteht in dem hohen Arbeitsdruck, der für eine Durchführung des Verfahrens erforderlich ist. Soll ein derartiger Beschichtungsschritt in komplexe Produktionsabläufe in Vakuumanlagen integriert werden, wird unter Umständen ein hoher Aufwand für Maßnahmen der Druckentkopplung erforderlich. Insbesondere eine Kombination mit Sputterprozessen wird aus diesem Grunde zumeist unwirtschaftlich.

Es ist bekannt, Barriereschichten durch Sputtern aufzubringen. Gesputterte Einzelschichten zeigen oft bessere Barriereeigenschaften als PECVD-Schichten. Für gesputtertes AINO auf PET werden als Permeationswerte beispielsweise WVTR = 0,2 g/m²d und OTR = 1 cm³/m²d angegeben [Thin Solid Films 388 (2001) 78-86]. Daneben sind zahlreiche andere Materialien bekannt, die insbesondere durch reaktives Sputtern zur Herstellung von transparenten Barriereschichten verwendet werden. Die so hergestellten Schichten weisen jedoch für Displayanwendungen ebenfalls zu geringe Barrierewirkungen auf. Ein weiterer Nachteil derartiger Schichten liegt in ihrer geringen mechanischen Belastbarkeit. Schädigungen, die durch technologisch unvermeidbare Beanspruchungen während der Weiterverarbeitung oder der Benutzung auftreten, führen meist zu einer deutlichen Verschlechterung der Barrierewirkung. Das macht gesputterte Einzelschichten für Barriereanwendungen häufig unbrauchbar.

Es ist bekannt, Einzelschichten als Barriereschichten aufzudampfen. Durch dieses PVD-Verfahren können ebenfalls verschiedene Materialien direkt oder reaktiv auf verschiedensten Substraten abgeschieden werden. Für Barriereanwendungen ist beispielsweise die reaktive Bedampfung von PET-Substraten mit Al₂O₃ bekannt [Surface and Coatings Technology 125 (2000) 354-360].
Hierbei werden Permeationswerte von WVTR = 1 g/m²d und OTR = 5 -cm³/m²d erreicht. Diese Werte sind ebenfalls viel zu hoch, um derart beschichtete Materialien als Barriereschichten in Displays zu verwenden. Sie sind häufig mechanisch noch weniger belastbar als gesputterte Einzelschichten. Außerdem ist eine direkte Verdampfung meist mit einer hohen Verdampfungsgeschwindigkeit oder -rate verbunden. Das bedingt bei der Herstellung von in Barriereanwendungen üblichen dünnen Schichten entsprechend hohe Substratgeschwindigkeiten, um eine zu starke Beaufschlagung des Substrates zu vermeiden. Eine Kombination mit Prozessschritten, die eine wesentlich geringere Durchlaufgeschwindigkeit erfordern, ist somit in Durchlaufanlagen nahezu unmöglich. Das betrifft insbesondere die Kombination mit Sputterprozessen.

Es ist bekannt, dass sich die mechanische Beständigkeit anorganischer Aufdampfschichten verbessern lässt, wenn während der Verdampfung eine organische Modifizierung vorgenommen wird. Dabei erfolgt der Einbau organischer Bestandteile in die sich während des Schichtwachstums ausbildende anorganische Matrix. Offenbar kommt es durch den Einbau dieser weiteren Bestandteile in die anorganische Matrix zu einer Erhöhung der Elastizität der gesamten Schicht, was die Gefahr von Brüchen in der Schicht deutlich reduziert. Stellvertretend als zumindest für Barriereanwendungen geeignet sei in diesem Zusammenhang ein Kombinationsprozess genannt, der eine Elektronenstrahlverdampfung von SiOₓ mit dem Einlass von HMDSO kombiniert (DE 195 48 160 C1). Für Displayanwendungen erforderliche niedrige Permeationsraten lassen sich mit derart hergestellten Schichten allerdings nicht erzielen. Nachteilig ist außerdem, dass die Elektronenstrahlverdampfung die bereits angesprochenen hohen Beschichtungsraten bedingt, was eine Kombination mit vielen anderen Prozessschritten deutlich erschwert.

Es ist bekannt, Barriereschichten in mehreren Beschichtungsschritten aufzubringen. Ein Verfahren bildet der sogenannte PML-Prozess (Polymer multilayer) (1999 Materials Research Society, p. 247-254); [J. D. Affinito, M. E. Gross, C. A. Coronado, G. L. Graff, E. N. Greenwell and P.M. Martin, Society of Vacuum Coaters, 39th Annual Technical Conference Proceedings (1996) p. 392-397]. Beim PML Prozess wird mittels Verdampfer ein flüssiger Acrylat-Film auf das Substrat aufgebracht, der mittels Elektronenstrahltechnik oder UV-Bestrahlung ausgehärtet wird. Dieser weist für sich keine besonders hohe Barrierewirkung auf. Anschließend erfolgt eine Beschichtung des ausgehärteten Acrylatfilms mit einer oxidischen Zwischenschicht, auf die wiederum ein Acrylatfilm aufgebracht wird. Diese Vorgehensweise wird bei Bedarf mehrfach wiederholt. Die Permeationswerte eines derart erzeugten Schichtstapels, also einer Kombination einzelner Acrylatschichten mit oxidischen Zwischenschichten, liegt unterhalb der Messgrenze von konventionellen Permeationsmessgeräten.
Nachteile bestehen vor allem im notwendigen Einsatz aufwendiger Anlagentechnik. Vakuumanlagen müssen zwingend nach dem Mehrkammerprinzip arbeiten, was mit einem hohen Preis verbunden ist. Außerdem bildet sich zunächst ein flüssiger Film auf dem Substrat, der ausgehärtet werden muss. Das führt zu einer verstärkten Anlagenverschmutzung, was Wartungszyklen verkürzt. Der Prozess ist ebenfalls für hohe Bandgeschwindigkeiten optimiert und daher in-line schlecht zu kombinieren mit langsameren Beschichtungsprozessen, insbesondere einem Sputterprozess.

Es ist weiterhin bekannt, bei der Abscheidung von Diffusionssperrschichten, also Barriereschichten, Magnetronplasmen für eine Plasmapolymerisation einzusetzen (EP 0 815 283 B1); [S. Fujimaki, H. Kashiwase, Y. Kokaku, Vacuum 59 (2000) p. 657-664]. Hierbei handelt es sich um PECVD-Prozesse, die direkt durch das Plasma einer Magnetronentladung aufrechterhalten werden. Beispielhaft steht hierfür die Verwendung eines Magnetronplasmas für PECVD-Beschichtung zur Abscheidung von Schichten mit einem Kohlenstoffgerüst, wobei als Precursor CH₄ dient. Derartige Schichten weisen jedoch ebenfalls eine für Displayanwendungen ungenügende Barrierewirkung auf.

Der Erfindung liegt die Aufgabe zu Grunde ein Verfahren zur Herstellung eines transparenten Barriereschichtsystems anzugeben, dessen Barrierewirkung ausreichend hoch ist, um die Schicht in Displayanwendungen einzusetzen, wobei das Verfahren sowohl von der Beschichtungsgeschwindigkeit als auch von den Vakuumanforderungen mit dem Magnetronsputtern kompatibel, also anlagentechnisch einfach kombinierbar sein soll.

Erfindungsgemäß wird die Aufgabe durch ein Verfahren entsprechend Anspruch 1 gelöst. Weitere vorteilhafte Ausgestaltungen des Verfahrens finden sich in den Ansprüchen 2 bis 27.

Die Erfindung nutzt die Eigenschaften keramischer Barriereschichten aus. Diese zeigen über einen weiten Dickenbereich hinweg eine Abhängigkeit der Barrierewirkung von der Schichtdicke. Versuche haben gezeigt, dass bei gleicher Gesamtdicke eine dicke Einzelschicht manchmal eine deutlich geringere Barrierewirkung zeigt als mehrere dünne Teilschichten, die durch andere, weitgehend barriereneutrale Zwischenschichten voneinander getrennt sind. Der umgekehrte Fall wurde nicht beobachtet. Es wurde weiter festgestellt, dass eine dünnere Einzelschicht zwar eine geringere Barrierewirkung zeigt als eine dickere, dass die dünnere Schicht aber bei mechanischer Beanspruchung ihre Barrierewirkung erst bei viel stärkerer Beanspruchung bzw. Deformation verliert als die dickere Schicht.

Die Barrierewirkung keramischer Schichten wird im Wesentlichen durch die Defektdichte und die Haftung der Schicht auf dem Substrat oder benachbarten Schichten bestimmt. Die teilweise hervorragende Barrierewirkung von Schichtstapeln, die mehrere dünne keramische Schichten enthalten, beruht offenbar darauf, dass Defekte in den einzelnen Schichten gegeneinander versetzt auftreten. Wo das nicht der Fall ist, erhöht sich bei gleicher Gesamtdicke der keramischen Beschichtung die Barrierewirkung eines Schichtstapels nur unwesentlich gegenüber der Barrierewirkung einer keramischen Einzelschicht.

Das erfindungsgemäße Verfahren basiert auf der abwechselnden Abscheidung von rein keramischen Schichten durch Magnetronsputtern und solchen Schichten, die mittels einem metall-organischen Precursor, der in einem Magnetronplasma umgesetzt wird, abgeschieden werden.

Das Verfahren für die Schichtabscheidung mittels metall-organischem Precursor basiert auf der Zersetzung einer dampfförmigen metall-organischen Verbindung in einem Magnetronplasma, verbunden mit der Abscheidung einer organisch modifizierten Metallverbindung. Dabei hat das Metall seinen Ursprung in der metall-organischen Verbindung, während weitere Schichtkomponenten sowohl aus der metall-organischen Verbindung stammen als auch zusätzlich in Gasform eingelassen werden können.

Die rein keramischen Schichten werden durch Magnetronsputtern aufgebracht. Dies kann in einem reaktiven oder nichtreaktiven Prozess geschehen.

Es hat sich gezeigt, dass durch die Schichtabscheidung mittels metall-organischem Precursor Zwischenschichten entstehen, die eine besonders effektive Steigerung der Barrierewirkung der keramischen Schichten bewirken. Offenbar weisen sie eine Struktur auf, die verhindert, dass sich das Wachstum von Defekten in den keramischen Schichten über mehrere Schichten hinweg fortsetzen kann. Dadurch können sich zwar in jeder einzelnen keramischen Schicht neue Defekte bilden, die in manchen Fällen durch die gesamte Dicke der Einzelschicht reichen können. Das Defektwachstum endet jedoch an der Zwischenschicht. Offenbar bildet sich durch die Art und Weise der Abscheidung der Zwischenschichten, die ein PECVD-Verfahren darstellt, in den Zwischenschichten eine Struktur heraus, die von der Struktur des Untergrundes nahezu unabhängig ist. Bis an eine Zwischenschicht heranreichende Defekte einer keramischen Schicht führen nicht zu Strukturveränderungen in der Zwischenschicht, die sich durch die gesamte Dicke der Zwischenschicht fortsetzen. Defekte einer im Schichtstapel befindlichen keramischen Schicht können somit nicht das Defektwachstum in einer anderen keramischen Schicht initiieren. Die Zwischenschichten führen zu einer Glättung defektbehafteter Oberflächen, weshalb sie im Folgenden im Sinne der Erfindung auch als Glättungsschichten bezeichnet werden. Durch den statistisch bedingten Versatz der Defekte in den einzelnen Schichten werden Permeationswege zwischen Defekten zweier keramischer Schichten erheblich verlängert.

Ein weiterer Vorteil des erfindungsgemäßen Verfahrens besteht darin, dass sich durch das Aufbringen der keramischen Schichten durch Sputtern eine ausgezeichnete Haftung zwischen den einzelnen Schichten des entstehenden Schichtstapels erzielen lässt. Das führt zu einer weiteren Verbesserung der Barrierewirkung. Es lassen sich bereits durch ein Schichtsystem, das aus zwei transparenten Keramikschichten und einer Glättungsschicht besteht, Permeationswerte von WVTR = 0,05 g/m²d und OTR = 0,2 cm³/m²d erreichen. Die Barrierewirkung lässt sich durch Variation der Anzahl der Einzelschichten auf einfache Weise an vorgegebene Mindestanforderungen anpassen. Es lassen sich sogar Permeationsraten erzielen, die unterhalb der Messgrenze konventioneller Permeationsmessgeräte liegen.

Es handelt sich bei der Erfindung um ein Verfahren zur Herstellung eines Ultrabarriere-Schichtsystems durch Vakuumbeschichtung eines Substrates mit einem Schichtstapel, der als Wechselschichtsystem aus Glättungsschichten und transparenten keramischen Schichten ausgebildet wird, mindestens jedoch eine Glättungsschicht zwischen zwei transparenten keramischen Schichten umfasst, welche durch Sputtern aufgebracht werden, wobei während der Abscheidung der Glättungsschicht ein Monomer in eine evakuierte Beschichtungskammer eingelassen wird, in der ein Magnetronplasma betrieben wird. Die Abscheidung beider Schichttypen des Wechselschichtsystems erfolgt also im Wesentlichen jeweils unter der Einwirkung eines Magnetronplasmas. Dadurch sind beide Beschichtungsschritte sehr einfach in einer Vakuumanlage kombinierbar, da die Anforderungen an das Vakuum eine aufwendige Druckentkopplung überflüssig machen. Besonders stabil lässt sich das Verfahren betreiben, wenn sowohl für die Abscheidung der keramischen Schicht als auch zur Abscheidung der Glättungsschicht eine Magnetronanordung aus einem oder mehreren Magnetrons in Verbindung mit einer gepulsten Energieeinspeisung (1 kHz bis 300 kHz) verwendet wird. Dies verhindert zum einen die verstärkte Ausbildung von Bogenentladungen, und zum anderen bei der Verwendung von zwei oder mehr Targets und bipolarer Energieeinspeisung die übermäßige Bedeckung der Targets mit Reaktionsprodukten aus dem Beschichtungsprozess. Besonders effektiv arbeiten auf diese Weise Doppelmagnetrons, von denen jeweils eines als Kathode und eines als Anode fungiert und deren Polarität wechselt.

Besonders vorteilhaft ist es, wenn zur Aufrechterhaltung des Magnetronplasmas während der Abscheidung der Glättungsschicht ein Magnetron verwendet wird, das mit einem Target bestückt ist, das aus einem Material besteht, das mit Stickstoff oder Sauerstoff reaktiv umgesetzt werden kann. Dadurch kann ein derartiges Magnetron durch Wechsel des eingelassenen Gases einerseits unter Einlass von Reaktivgas zur Abscheidung transparenter keramischer Schichten und andererseits zur Unterstützung der Plasmapolymerisation bei Monomereinlass verwendet werden. In einer vorteilhaften Ausgestaltung des Verfahrens erfolgt die Abscheidung des Wechselschichtsystems durch wechselweisen Einlass von HMDSO und Sauerstoff.

Besonders vorteilhaft ist es, wenn die Aufrechterhaltung des Magnetronplasmas unabhängig vom Einlass der umzusetzenden Gase erfolgt. Das erreicht man durch zusätzlichen Einlass eines Arbeitsgases, vorzugsweise eines Edelgases. Besonders vorteilhaft lässt sich hierfür Argon verwenden. Als einzulassende Monomere haben sich erfindungsgemäß Kohlenwasserstoffe, Silane, Si-Organika oder Metallorganika bewährt. Als besonders vorteilhaft hat sich der Einsatz von HMDSO erwiesen, insbesondere, wenn als transparente keramische Schichten Oxide abgeschieden werden.

Besonders gute Resultate ergeben sich, wenn während der Abscheidung der Glättungsschicht zusätzlich zum Einlass von Monomeren Sauerstoff, Stickstoff und/oder Wasserstoff als Reaktivgas eingelassen wird. Während der Abscheidung der Glättungsschicht wird vorteilhafterweise ein Prozessdruck von 0.1 Pa bis 10 Pa eingestellt, was diesen Beschichtungsschritt problemlos mit Zerstäubungsprozessen kombinierbar macht. Deshalb ist es besonders vorteilhaft, wenn die Abscheidung der transparenten keramischen Schichten durch Magnetronsputtern, vorzugsweise reaktives Magnetronsputtern, erfolgt, wobei als Reaktivgas Stickstoff, Sauerstoff und/oder Wasserstoff eingelassen wird.

Besonders vorteilhaft ist es, als transparente keramische Schicht SiO₂, Al₂O₃ oder SiN abzuscheiden.

Die Beschichtung kann auf stationären oder bewegten bandförmigen Substraten vorgenommen werden, was das Verfahren vielseitig verwendbar macht. Besonders geeignet ist es zur Beschichtung von Kunststoffsubstraten, insbesondere, wenn die Substrattemperatur auf weniger als 200 °C gehalten wird, was z. B. über die Einstellung einer entsprechenden Plasmaleistung problemlos möglich ist. Es lassen sich mit dem erfindungsgemäßen Verfahren bei noch niedrigerer Einstellung der Substrattemperatur auch extrem temperaturempfindliche Substrate schädigungsfrei beschichten.

Besonders wirkungsvolle Barrieresysteme lassen sich erzielen, wenn die Beschichtungsraten und/oder die Substratgeschwindigkeit so eingestellt werden, dass Plasmapolymerschichten als Glättungsschichten mit einer Schichtdicke von 50 nm bis 5 µm und transparente keramische Schichten mit einer Schichtdicke von 5 nm bis 500 nm abgeschieden werden.

Durch die gute Kombinierbarkeit der einzelnen Beschichtungsschritte ist es möglich, alle Einzelschichten unter der Wirkung des Plasmas einer einzigen Magnetronanordnung abzuscheiden. Das ermöglicht den Einsatz sehr kompakter Anlagen. Vorteilhaft ist hierbei, wenn während der Abscheidung des Wechselschichtsystems die eingelassenen Flüsse von Monomer und Reaktivgas und/oder Arbeitsgas allmählich verändert werden und zumindest zeitweise gleichzeitig erfolgen, so dass einzelne Schichten des Wechselschichtsystems gradientenförmig ineinander übergehen. Eine besonders einfache Ausführungsform ergibt sich, wenn Reaktivgas und Monomer über einen gemeinsamen Gaseinlass eingelassen werden.

Das erfindungsgemäße Verfahren lässt sich auch mit Vorteil ausführen, wenn das Wechselschichtsystem mittels mindestens einer Magnetronanordnung abgeschieden wird und der Einlass von Monomer und Reaktivgas und/oder Arbeitsgas an unterschiedlichen Orten erfolgt, so dass sich bei Durchlaufen des Beschichtungsbereiches auf einem bewegten Substrat nacheinander die Schichten des Wechselschichtsystems abscheiden. Besonders vorteilhaft kann es dabei sein, wenn das Wechselschichtsystem mittels mindestens einer Magnetronanordnung abgeschieden wird und der Einlass von Monomer und Reaktivgas und/oder Arbeitsgas an unterschiedlichen Orten erfolgt, so dass sich im Bereich des Magnetronplasmas ein deutlicher Partialdruckgradient zwischen den eingelassenen Gasen ausbildet derart, dass sich bei Durchlaufen des Beschichtungsbereiches auf einem bewegten Substrat nacheinander Schichten abscheiden, die gradientenförmig ineinander übergehen. Dabei kann der Beschichtungsbereich mehrfach durchlaufen werden, um die Anzahl der Einzelschichten zu erhöhen. Auch für Ausführungsformen des erfindungsgemäßen Verfahrens mit gleichzeitigem Einlass von Monomer und Reaktivgas ist die Kombination von HMDSO und Sauerstoff von Vorteil. Dabei kann es zweckmäßig sein den Einlass von Reaktivgas und Arbeitsgas über einen gemeinsamen Gaseinlass vorzunehmen.

An drei Ausführungsbeispielen wird das erfindungsgemäße Verfahren näher erläutert.

In einem ersten Ausführungsbeispiel wird in einer Vakuumbeschichtungsanlage in einer Beschichtungsstation ein stationär angeordnetes Kunststoffsubstrat beschichtet. Dazu wird eine metall-organische Verbindung (HMDSO) in flüssiger Form in einem Vorratsbehälter untergebracht und über einen Flowcontroller einem Verdampfer zugeführt, wo die Flüssigkeit verdampft wird. Über eine beheizte Zuleitung und einen ebenfalls beheizten weiteren Flowcontroller wird der Dampf in den zuvor evakuierten und mit Ar bis zu einem Druck zwischen 0.1 Pa und 10 Pa gefüllten Prozessraum eingelassen. Zusätzlich können andere Reaktivgase wie Sauerstoff oder Stickstoff eingelassen werden. Alle Gase werden bevorzugt in der unmittelbaren Nähe eines im Prozessraum gezündeten Magnetronplasmas eingelassen. Das Plasma wird von einer Doppelmagnetronanordnung erzeugt, die bipolar gepulst betrieben wird, wobei die Pulsfrequenz zwischen 1 kHz und 100 kHz liegt.
Die Targets der Magnetrons bestehen aus Aluminium.
Begonnen wird mit dem Einlass von Sauerstoff. Die Aluminiumtargets werden somit in einem Gemisch aus Argon und Sauerstoff zerstäubt, wodurch eine transparente keramische Schicht (Al₂O) in einem reaktiven Sputterprozess aufgebracht wird. Bei Erreichen einer Sollschichtdicke wird die Sputterrate reduziert und der Sauerstoffeinlass beendet. Anschließend erfolgt der Einlass von HMDSO, wodurch unter der Einwirkung des Magnetronplasmas eine Glättungsschicht abgeschieden wird. Ist deren Sollschichtdicke erreicht, wird der Einlass von HMDSO beendet und mit der reaktiven Aufstäubung einer Aluminiumoxidschicht fortgefahren. Dieser Zyklus wird bei Bedarf mehrfach durchlaufen, bis sich eine geforderte Barrierewirkung erwarten lässt. Diese kann durch anschließende Messungen überprüft werden.
Bei einer derartigen stationären Beschichtung kann durch Wahl eines geeigneten Targetmaterials wie Si, Ti oder Al das Aufbringen eines Wechselschichtsystems in analoger Weise durch einfachen Wechsel der eingelassenen Gase zwischen metall-organischem Dampf und O₂ oder N₂ erfolgen.
Der Vorteil dieser Variante ist, dass nur eine einzige Beschichtungsstation nötig ist, da das Magnetronplasma einmal zur Schichtabscheidung der keramischen Schicht und einmal zur Umsetzung des metall-organischen Precursors verwendet wird.

In einem zweiten Ausführungsbeispiel wird in einer Vakuumbeschichtungsanlage, die mit einem Abwickel und einem Aufwickel für bandförmige Substrate ausgerüstet ist, in mindestens einer Beschichtungsstation ein kontinuierlich bewegtes Kunststoffsubstrat beschichtet. Dazu wird eine metall-organische Verbindung (HMDSO) in flüssiger Form in einem Vorratsbehälter untergebracht und über einen Flowcontroller einem Verdampfer zugeführt, wo die Flüssigkeit verdampft wird. Über eine beheizte Zuleitung und einen ebenfalls beheizten weiteren Flowcontroller wird der Dampf in den zuvor evakuierten und mit Ar bis zu einem Druck zwischen 0.1 Pa und 10 Pa gefüllten Prozessraum eingelassen. Zusätzlich können andere Reaktivgase wie Sauerstoff oder Stickstoff eingelassen werden. Alle Gase werden bevorzugt in der unmittelbaren Nähe eines im Prozessraum gezündeten Magnetronplasmas eingelassen. Das Plasma wird von einer Doppelmagnetronanordnung erzeugt, die bipolar gepulst betrieben wird, wobei die Pulsfrequenz zwischen 1 kHz und 100 kHz liegt. Die Targets der Magnetrons bestehen aus Aluminium.

Die Vakuumbeschichtungsanlage wird mit nur einer Beschichtungsstation betrieben. Es wird zunächst mit dem Einlass von Sauerstoff begonnen. Die Aluminiumtargets werden in einem Gemisch aus Argon und Sauerstoff zerstäubt, wodurch eine transparente keramische Schicht (Al₂O) in einem reaktiven Sputterprozess aufgebracht wird. Die Schichtdicke der transparenten keramischen Schicht kann über die Vorschubgeschwindigkeit des bandförmigen Substrates und über die dem Sputterprozess zugeführte elektrische Leistung eingestellt werden. Ist die gewünschte Länge des bandförmigen Substrates beschichtet, wird der Beschichtungsprozess unterbrochen und-die Bandlaufrichtung umgekehrt. Danach erfolgt der Einlass von HMDSO, wodurch unter Einwirkung des Magnetronplasmas eine Glättungsschicht bei umgekehrter Bandlaufrichtung abgeschieden wird.
Dieser Zyklus wird bei Bedarf mehrfach mit wechselnder Bandlaufrichtung durchlaufen, bis sich eine geforderte Barrierewirkung erwarten lässt. Diese kann durch anschließende Messungen überprüft werden. Auf diese Weise lassen sich in einer einzigen Beschichtungsstation Schichtstapel aus beliebig vielen Einzelschichten auf langgestreckten Substraten herstellen.

In einem dritten Ausführungsbeispiel wird in einer Vakuumbeschichtungsanlage, die mit einem Abwickel und einem Aufwickel für bandförmige Substrate ausgerüstet ist, in mehreren Beschichtungsstationen ein kontinuierlich bewegtes Kunststoffsubstrat beschichtet. Dabei wird das Substrat nacheinander an benachbarten Beschichtungsstationen vorbei geführt, die entsprechend den vorangegangenen Beispielen entweder für einen reaktiven Sputterprozess zur Abscheidung von Al₂O₃ oder für eine plasmagestützte Abscheidung einer erfindungsgemäßen Glättungsschicht unter Einlass von HMDSO eingerichtet sind. Entspricht die Zahl der Beschichtungsstationen der Zahl der gewünschten Einzelschichten im herzustellenden Barriereschichtsystem, kann dieses in einem einzigen Durchlauf durch die Beschichtungsanlage aufgebracht werden. Daraus resultiert eine besonders hohe Effektivität derartiger Anlagen.
In allen drei Ausführungsbeispielen wird durch den Betrieb der Magnetrons mit einer gepulsten Energieeinspeisung zum einen die verstärkte Ausbildung von Bogenentladungen verhindert, zum anderen wird durch Verwendung von zwei Targets und bipolarer Energieeinspeisung die übermäßige Bedeckung der Targets mit Reaktionsprodukten aus dem Beschichtungsprozess verringert, was für eine stabile Prozessführung sorgt.

## Patentansprüche

1. Verfahren zur Herstellung eines Ultrabarriere-Schichtsystems durch Vakuumbeschichtung eines Substrates mit einem Schichtstapel, der als Wechselschichtsystem aus Glättungsschichten und transparenten keramischen Schichten ausgebildet wird, mindestens jedoch eine Glättungsschicht zwischen zwei transparenten keramischen Schichten umfasst, welche durch Sputtern aufgebracht werden, **dadurch gekennzeichnet, dass** während der Abscheidung der Glättungsschicht ein Monomer in eine evakuierte Beschichtungskammer eingelassen wird, in der ein Magnetronplasma betrieben wird.

2. Verfahren nach Anspruch 1, **dadurch gekennzeichnet, dass** das Magnetronplasma während der Abscheidung der Glättungsschicht gepulst mit einer Pulsfrequenz von 1 kHz bis 300 kHz betrieben wird.

3. Verfahren nach Anspruch 1 oder 2, **dadurch gekennzeichnet, dass** zur Aufrechterhaltung des Magnetronplasmas während der Abscheidung der Glättungsschicht ein Magnetron verwendet wird, das mit einem Target bestückt ist, das aus einem Material besteht, das mit Stickstoff oder Sauerstoff reaktiv umgesetzt werden kann.

4. Verfahren nach mindestens einem der Ansprüche 1 bis 3, **dadurch gekennzeichnet, dass** zur Aufrechterhaltung des Plasmas während der Abscheidung der Glättungsschicht ein Doppelmagnetron verwendet wird.

5. Verfahren nach mindestens einem der Ansprüche 1 bis 4, **dadurch gekennzeichnet, dass** als Arbeitsgas ein Edelgas verwendet wird.

6. Verfahren nach mindestens einem der Ansprüche 1 bis 5, **dadurch gekennzeichnet, dass** als Monomer Kohlenwasserstoffe, Silane, Si-Organika oder Metallorganika eingelassen werden.

7. Verfahren nach mindestens einem der Ansprüche 1 bis 6, **dadurch gekennzeichnet, dass** während der Abscheidung der Glättungsschicht zusätzlich zum Einlass von Monomeren Sauerstoff, Stickstoff und/oder Wasserstoff als Reaktivgas eingelassen wird.

8. Verfahren nach mindestens einem der Ansprüche 1 bis 7, **dadurch gekennzeichnet, dass** während der Abscheidung der Glättungsschicht ein Prozessdruck von 0.1 Pa bis 10 Pa eingestellt wird.

9. Verfahren nach mindestens einem der Ansprüche 1 bis 8, **dadurch gekennzeichnet, dass** die Abscheidung der transparenten keramischen Schichten durch Magnetronsputtern erfolgt.

10. Verfahren nach Anspruch 9, **dadurch gekennzeichnet, dass** die Abscheidung der transparenten keramischen Schichten durch reaktives Magnetronsputtern erfolgt, wobei als Reaktivgas Stickstoff, Sauerstoff und/oder Wasserstoff eingelassen wird.

11. Verfahren nach mindestens einem der Ansprüche 1 bis 10, **dadurch gekennzeichnet, dass** als transparente keramische Schicht Al₂O₃ abgeschieden wird.

12. Verfahren nach mindestens einem der Ansprüche 1 bis 10, **dadurch gekennzeichnet, dass** als transparente keramische Schicht SiO₂ abgeschieden wird.

13. Verfahren nach mindestens einem der Ansprüche 1 bis 10, **dadurch gekennzeichnet, dass** als transparente keramische Schicht SiN abgeschieden wird.

14. Verfahren nach mindestens einem der Ansprüche 1 bis 13, **dadurch gekennzeichnet, dass** die Beschichtung auf stationären Substraten vorgenommen wird.

15. Verfahren nach mindestens einem der Ansprüche 1 bis 13, **dadurch gekennzeichnet, dass** die Beschichtung auf bewegten bandförmigen Substraten vorgenommen wird.

16. Verfahren nach mindestens einem der Ansprüche 1 bis 15, **dadurch gekennzeichnet, dass** während der Beschichtung die Substrattemperatur unter 200 °C gehalten wird.

17. Verfahren nach mindestens einem der Ansprüche 1 bis 16, **dadurch gekennzeichnet, dass** die Beschichtung auf Kunststoffsubstraten vorgenommen wird.

18. Verfahren nach mindestens einem der Ansprüche 1 bis 17, **dadurch gekennzeichnet, dass** die Beschichtungsraten und/oder die Substratgeschwindigkeit so eingestellt werden, dass Plasmapolymerschichten als Glättungsschichten mit einer Schichtdicke von 50 nm bis 5 µm und transparente keramische Schichten mit eine Schichtdicke von 5 nm bis 500 nm abgeschieden werden.

19. Verfahren nach mindestens einem der Ansprüche 1 bis 18, **dadurch gekennzeichnet, dass** das Wechselschichtsystem mittels einer Magnetronanordnung abgeschieden wird, in deren Plasma wechselweise ein Monomer und ein Reaktivgas eingelassen wird.

20. Verfahren nach Anspruch 19, **dadurch gekennzeichnet, dass** die Abscheidung des Wechselschichtsystems durch wechselweisen Einlass von HMDSO und Sauerstoff vorgenommen wird.

21. Verfahren nach Anspruch 19 oder 20, **dadurch gekennzeichnet, dass** während der Abscheidung des Wechselschichtsystems die eingelassenen flüsse von Monomer und Reaktivgas und/oder Arbeitsgas allmählich verändert werden und zumindest zeitweise gleichzeitig erfolgen, so dass einzelne Schichten des Wechselschichtsystems gradientenförmig ineinander übergehen.

22. Verfahren nach mindestens einem der Ansprüche 19 bis 21, **dadurch gekennzeichnet, dass** Reaktivgas und Monomer über einen gemeinsamen Gaseinlass eingelassen werden.

23. Verfahren nach mindestens einem der Ansprüche 1 bis 18, **dadurch gekennzeichnet, dass** das Wechselschichtsystem mittels mindestens einer Magnetronanordnung abgeschieden wird und der Einlass von Monomer und Reaktivgas und/oder Arbeitsgas an unterschiedlichen Orten erfolgt, so dass sich bei Durchlaufen des Beschichtungsbereiches auf einem bewegten Substrat nacheinander die Schichten des Wechselschichtsystems abscheiden.

24. Verfahren nach mindestens einem der Ansprüche 1 bis 18, **dadurch gekennzeichnet, dass** das Wechselschichtsystem mittels mindestens einer Magnetronanordnung abgeschieden wird und der Einlass von Monomer und Reaktivgas und/oder Arbeitsgas an unterschiedlichen Orten erfolgt, so dass sich im Bereich des Magnetronplasmas ein deutlicher Partialdruckgradient zwischen den eingelassenen Gasen ausbildet derart, dass sich bei Durchlaufen des Beschichtungsbereiches auf einem bewegten Substrat nacheinander Schichten abscheiden, die gradientenförmig ineinander übergehen.

25. Verfahren nach Anspruch 23 oder 24, **dadurch gekennzeichnet, dass** ein bewegtes Substrat mehrmals durch den Beschichtungsbereich geführt wird.

26. Verfahren nach einem der Ansprüche 23 bis 25, **dadurch gekennzeichnet, dass** die Abscheidung des Wechselschichtsystems durch gleichzeitigen Einlass von HMDSO und Sauerstoff vorgenommen wird.

27. Verfahren nach mindestens einem der Ansprüche 23 bis 26, **dadurch gekennzeichnet, dass** Reaktivgas und Arbeitsgas über einen gemeinsamen Gaseinlass eingelassen werden.

## Claims

1. Method for producing an ultra barrier layer system by vacuum deposition on a substrate with a layer stack that is configured as an alternating layer system of smoothing layers and transparent ceramic layers, but comprises at least one smoothing layer between two transparent ceramic layers, which are applied by way of sputtering, **characterized in that** during the deposition of the smoothing layer, a monomer is admitted into an evacuated coating chamber in which a magnetron plasma is operated.

2. Method according to Claim 1, **characterized in that** the magnetron plasma is operated during the deposition of the smoothing layer in a pulsed fashion with a pulse frequency of 1 kHz to 300 kHz.

3. Method according to Claim 1 or 2, **characterized in that** for maintaining the magnetron plasma during the deposition of the smoothing layer, a magnetron is used that is provided with a target which is made of a material that can be reacted with nitrogen or oxygen.

4. Method according to at least one of Claims 1 to 3, **characterized in that** for maintaining the plasma during the deposition of the smoothing layer, a dual magnetron is used.

5. Method according to at least one of Claims 1 to 4, **characterized in that** a noble gas is used as a working gas.

6. Method according to at least one of Claims 1 to 5, **characterized in that** hydrocarbons, silanes, Si-organics or metal organics are admitted as the monomer.

7. Method according to at least one of Claims 1 to 6, **characterized in that** during the deposition of the smoothing layer, oxygen, nitrogen and/or hydrogen is admitted as a reactive gas in addition to the admission of monomers.

8. Method according to at least one of Claims 1 to 7, **characterized in that** during the deposition of the smoothing layer, a process pressure of 0.1 Pa to 10 Pa is established.

9. Method according to at least one of Claims 1 to 8, **characterized in that** the deposition of the transparent ceramic layers takes place by way of magnetron sputtering.

10. Method according to Claim 9, **characterized in that** the deposition of the transparent ceramic layers takes place by way of reactive magnetron sputtering, with nitrogen, oxygen and/or hydrogen being admitted as the reactive gas.

11. Method according to at least one of Claims 1 to 10, **characterized in that** the transparent ceramic layer deposited is Al₂O₃.

12. Method according to at least one of Claims 1 to 10, **characterized in that** the transparent ceramic layer deposited is SiO₂.

13. Method according to at least one of Claims 1 to 10, **characterized in that** the transparent ceramic layer deposited is SiN.

14. Method according to at least one of Claims 1 to 13, **characterized in that** coating takes place on stationary substrates.

15. Method according to at least one of Claims 1 to 13, **characterized in that** coating takes place on moving belt-type substrates.

16. Method according to at least one of Claims 1 to 15, **characterized in that** during coating the substrate temperature is kept under 200°C.

17. Method according to at least one of Claims 1 to 16, **characterized in that** coating takes place on plastics substrates.

18. Method according to at least one of Claims 1 to 17, **characterized in that** the coating rates and/or the substrate speed are set such that plasma polymer layers as smoothing layers are deposited with a layer thickness of 50 nm to 5 µm and transparent ceramic layers are deposited with a layer thickness of 5 nm to 500 nm.

19. Method according to at least one of Claims 1 to 18, **characterized in that** the alternating layer system is deposited by means of a magnetron arrangement, in the plasma of which a monomer and a reactive gas are admitted in alternating fashion.

20. Method according to Claim 19, **characterized in that** the deposition of the alternating layer system is carried out by alternating admission of HMDSO and oxygen.

21. Method according to Claim 19 or 20, **characterized in that** during the deposition of the alternating layer system, the admitted flows of monomer and reactive gas and/or working gas are changed gradually and take place at the same time at least intermittently, with the result that individual layers of the alternating layer system merge into one another in the form of a gradient.

22. Method according to at least one of Claims 19 to 21, **characterized in that** reactive gas and monomer are admitted via a common gas inlet.

23. Method according to at least one of Claims 1 to 18, **characterized in that** the alternating layer system is deposited by means of at least one magnetron arrangement and the admission of monomer and reactive gas and/or working gas takes place at various locations, with the result that, as a moving substrate passes through the coating region, the layers of the alternating layer system are deposited in succession.

24. Method according to at least one of Claims 1 to 18, **characterized in that** the alternating layer system is deposited by means of at least one magnetron arrangement and the admission of monomer and reactive gas and/or working gas takes place at various locations, with the result that a clear partial pressure gradient forms in the region of the magnetron plasma between the admitted gases such that, as a moving substrate passes through the coating region, layers that merge into one another in the form of a gradient are deposited in succession.

25. Method according to Claim 23 or 24, **characterized in that** a moving substrate is passed a number of times through the coating region.

26. Method according to one of Claims 23 to 25, **characterized in that** the deposition of the alternating layer system takes place by way of simultaneous admission of HMDSO and oxygen.

27. Method according to one of Claims 23 to 26, **characterized in that** reactive gas and working gas are admitted via a common gas inlet.

## Revendications

1. Procédé de production d'un système de couche barrière ultra par revêtement sous vide d'un substrat avec un empilement de couches, qui est réalisé sous la forme d'un système de couches alternées composé de couches de lissage et de couches céramiques transparentes, mais qui comprend au moins une couche de lissage entre deux couches céramiques transparentes, qui ont été déposées par pulvérisation, **caractérisé en ce que**, pendant le dépôt de la couche de lissage, on introduit un monomère dans une chambre de revêtement évacuée, dans laquelle on fait fonctionner un plasma magnétron.

2. Procédé selon la revendication 1, **caractérisé en ce que** l'on fait fonctionner le plasma magnétron de façon pulsée avec une fréquence de pulsation de 1 kHz à 300 kHz pendant le dépôt de la couche de lissage.

3. Procédé selon la revendication 1 ou 2, **caractérisé en ce que**, pour entretenir le plasma magnétron pendant le dépôt de la couche de lissage, on utilise un magnétron qui est équipé d'une cible, qui est constituée d'une matière qui peut être rendue réactive avec l'azote ou l'oxygène.

4. Procédé selon au moins une des réactions 1 à 3, **caractérisé en ce que**, pour entretenir le plasma magnétron pendant le dépôt de la couche de lissage, on utilise un magnétron double.

5. Procédé selon au moins une des revendications 1 à 4, **caractérisé en ce que** l'on utilise un gaz noble comme gaz de travail.

6. Procédé selon au moins une des revendications 1 à 5, **caractérisé en ce que** l'on introduit comme monomère des hydrocarbures, des silanes, des corps organo-siliceux ou des corps organométalliques.

7. Procédé selon au moins une des revendications 1 à 6, **caractérisé en ce que** l'on introduit de l'oxygène, de l'azote et/ou de l'hydrogène comme gaz réactif, en plus de l'introduction de monomères, pendant le dépôt de la couche de lissage.

8. Procédé selon au moins une des revendications 1 à 7, **caractérisé en ce que** l'on règle une pression de traitement de 0,1 Pa à 10 Pa pendant le dépôt de la couche de lissage.

9. Procédé selon au moins une des revendications 1 à 8, **caractérisé en ce que** l'on effectue le dépôt des couches céramiques transparentes par pulvérisation plasma magnétron.

10. Procédé selon la revendication 9, **caractérisé en ce que** l'on effectue le dépôt des couches céramiques transparentes par pulvérisation plasma réactif magnétron, dans lequel on introduit de l'azote, de l'oxygène et/ou de l'hydrogène comme gaz réactif.

11. Procédé selon au moins une des revendications 1 à 10, **caractérisé en ce que** l'on dépose du Al₂O₃ comme couche céramique transparente.

12. Procédé selon au moins une des revendications 1 à 10, **caractérisé en ce que** l'on dépose du SiO₂ comme couche céramique transparente.

13. Procédé selon au moins une des revendications 1 à 10, **caractérisé en ce que** l'on dépose du SiN comme couche céramique transparente.

14. Procédé selon au moins une des revendications 1 à 13, **caractérisé en ce que** l'on effectue le revêtement sur des substrats stationnaires.

15. Procédé selon au moins une des revendications 1 à 13, **caractérisé en ce que** l'on effectue le revêtement sur des substrats en forme de bandes en mouvement.

16. Procédé selon au moins une des revendications 1 à 15, **caractérisé en ce que** l'on maintient la température du substrat en dessous de 200°C pendant le revêtement.

17. Procédé selon au moins une des revendications 1 à 16, **caractérisé en ce que** l'on effectue le revêtement sur des substrats en matière plastique.

18. Procédé selon au moins une des revendications 1 à 17, **caractérisé en ce que** l'on règle les vitesses de revêtement et/ou la vitesse du substrat de telle manière que l'on dépose des couches polymères plasma comme couches de lissage avec une épaisseur de couche de 50 nm à 5 µm et des couches céramiques transparentes avec une épaisseur de couche de 5 nm à 500 nm.

19. Procédé selon au moins une des revendications 1 à 18, **caractérisé en ce que** l'on dépose le système de couches alternées au moyen d'un dispositif de magnétron, dans le plasma duquel on introduit alternativement un monomère et un gaz réactif.

20. Procédé selon la revendication 19, **caractérisé en ce que** l'on effectue le dépôt du système de couches alternées par une introduction alternée de HMDSO et d'oxygène.

21. Procédé selon la revendication 19 ou 20, **caractérisé en ce que** l'on fait varier graduellement les flux introduits de monomère et de gaz réactif et/ou de gaz de travail pendant le dépôt du système de couches alternées, et on les effectue au moins temporairement en même temps, de telle manière que des couches individuelles du système de couches alternées pénètrent l'une dans l'autre en forme de gradient.

22. Procédé selon au moins une des revendications 19 à 21, **caractérisé en ce que** l'on introduit le gaz réactif et le monomère par une entrée de gaz commune.

23. Procédé selon au moins une des revendications 1 à 18, **caractérisé en ce que** l'on dépose le système de couches alternées au moyen d'au moins un dispositif de magnétron et on effectue l'introduction de monomère et de gaz réactif et/ou de gaz de travail en des endroits différents, de telle manière que les couches du système de couches alternées se déposent l'une après l'autre sur un substrat en mouvement lors de la traversée de la zone de revêtement.

24. Procédé selon au moins une des revendications 1 à 18, **caractérisé en ce que** l'on dépose le système de couches alternées au moyen d'au moins un dispositif de magnétron et on effectue l'introduction de monomère et de gaz réactif et/ou de gaz de travail en des endroits différents, de telle manière qu'il se forme dans la zone du plasma magnétron un gradient distinct de pression partielle entre les gaz introduits, de telle manière qu'il se dépose l'une après l'autre sur le substrat en mouvement, pendant la traversée de la zone de revêtement, des couches qui pénètrent l'une dans l'autre en forme de gradient.

25. Procédé selon la revendication 23 ou 24, **caractérisé en ce que** l'on guide un substrat en mouvement plusieurs fois à travers la zone de revêtement.

26. Procédé selon au moins une des revendications 23 à 25, **caractérisé en ce que** l'on effectue le dépôt du système de couches alternées par introduction simultanée de HMDSO et d'oxygène.

27. Procédé selon au moins une des revendications 23 à 26, **caractérisé en ce que** l'on introduit du gaz réactif et du gaz de travail par une entrée de gaz commune.
